# EUROPÄISCHE PATENTSCHRIFT

(11) **EP 1 805 813 B1**
(45) Veröffentlichungstag und Bekanntmachung des Hinweises auf die Patenterteilung: **22.01.2020**
(21) Anmeldenummer: 05804392.8
(22) Anmeldetag: 25.10.2005
(51) Int. Cl.: H01L 33/54, H01L 33/58, H01L 33/60

(54) **ELEKTROMAGNETISCHE STRAHLUNG EMITTIERENDES HALBLEITERBAUELEMENT**
SEMICONDUCTOR COMPONENT EMITTING ELECTROMAGNETIC RADIATION
DISPOSITIF A SEMICONDUCTEUR EMETTANT UN RAYONNEMENT ELECTROMAGNETIQUE

(30) Priorität: 25.10.2004 DE 102004051921; 21.06.2005 DE 102005028748
(43) Veröffentlichungstag der Anmeldung: 11.07.2007
(73) Patentinhaber: OSRAM Opto Semiconductors GmbH, 93055 Regensburg (DE)
(72) Erfinder: BÖRNER, Mike, 93049 Regensburg (DE); MÖLLMER, Frank, 93080 Matting b. Pentling (DE)
(74) Vertreter: Zacco Patent- & Rechtsanwälte
(86) Internationale Anmeldenummer: PCT/DE2005/001909
(87) Internationale Veröffentlichungsnummer: WO 2006/045287

(56) Entgegenhaltungen:
- DE-A1- 4 232 637
- DE-A1- 10 345 516
- DE-A1- 19 535 777
- DE-A1- 19 945 919
- JP-A- H0 613 661
- JP-A- H11 154 766
- JP-A- 2003 303 998
- US-A- 6 095 666
- US-A- 6 137 121
- US-A1- 2004 041 222

## Beschreibung

Die Erfindung bezieht sich auf ein elektromagnetische Strahlung emittierendes Halbleiterbauelement gemäß dem Oberbegriff des Patentanspruches 1 und Verwendung eines entsprechenden Bauelements gemäß dem Oberbegriff des Patentanspruchs 10.

Insbesondere die immer fortschreitende Entwicklung neuer Chiptechnologien im Bereich der Leuchtdioden bedarf des Einsatzes neuer optischer Elemente in der Gehäusetechnologie. Ein sogenannter Dünnfilm-Leuchtdiodenchip (nähere Erläuterung siehe weiter unten) emittiert ca 85% seiner Strahlung von der Chipoberfläche, das heißt von einer von einem Trägersubstrat abgewandten Vorderseite einer strahlungserzeugenden Halbleiterschichtenfolge. Die restlichen 15% werden durch die Flanken der Halbleiterschichtenfolge zur Seite hin abgestrahlt.

Ein Dünnfilm-Leuchtdiodenchip zeichnet sich insbesondere durch folgende charakteristische Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert; und
- die Epitaxieschichtenfolge weist eine Dicke im Bereich von 20 µm oder weniger, insbesondere im Bereich von 10 µm auf.

Die Epitaxieschichtenfolge enthält weiterhin bevorzugt mindestens eine Halbleiterschicht mit zumindest einer Fläche, die eine Durchmischungsstruktur aufweist, die im Idealfall zu einer annähernd ergodischen Verteilung der Strahlung in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Ein Dünnfilm-Leuchtdiodenchip ist in guter Näherung ein Lambertscher Oberflächenstrahler und eignet sich von daher besonders gut für die Anwendung in einem Scheinwerfer.

Um mit einem solchen Dünnfilm-Leuchtdiodenchip ein optoelektronisches Bauelement mit einem definiert engen Abstrahlwinkel und möglichst hoher Strahlungsleistung zu erzielen, muß eine von der Vorderseite flach zur Seite ausgesandte Strahlung und die durch die Flanken der Halbleiterschichtenfolge seitlich emittierte Strahlung möglichst vollständig zur gewünschten optischen Achse des Bauelements hin und in den gewünschten Abstrahlkegel des Bauelements hinein umgelenkt werden, so dass auch diese Strahlung in dem gewünschten definiert engen Winkel aus dem Bauelement abgestrahlt wird.

Dokumente US6095666 A, JPH06013661 A, JPH11154766 A, DE19535777 A1, JP2003303998 A und DE4232637 A1 beschreiben optoelektronische Bauelemente, die eine Lösung zu dem oben genannten technischen Problem bieten.

Es ist demnach eine Aufgabe der vorliegenden Erfindung, ein Bauelementgehäuse bereitzustellen, bei dem mittels eines Dünnfilm-Leuchtdiodenchips oder eines eine ähnliche Abstrahlcharakteristik aufweisenden, elektromagnetische Strahlung aussendenden Körpers ein definierter Abstrahlwinkel des gewünschten optoelektronischen Bauelements erzielt werden kann und wobei auf einfache Weise ein gegenüber dem Durchmesser des restlichen Gehäusekörpers kleinerer Linsendurchmesser realisiert werden kann.

Diese Aufgabe wird mit einem optoelektronischen Bauelement und mit einem Bauelementgehäuse mit den Merkmalen des Patentanspruches 1 bzw. mit den Merkmalen des Patentanspruches 10 gelöst.

Vorteilhafte Ausführungsformen, Weiterbildungen und Verwendungen des Bauelements sind in den Unteransprüchen angegeben.

Der Offenbarungsgehalt der Patentansprüche wird hiermit ausdrücklich in die Beschreibung aufgenommen.

Ein Bauelementgehäuse für ein optoelektronisches Bauelement mit einem Strahlung emittierenden Körper gemäß der Erfindung umfasst insbesondere eine Reflektorwanne mit:
- einem Reflektorbereich (51) mit einer Innenfläche, dessen Querschnitt sich gesehen vom Strahlung emittierenden Körper (1) zu einer Vorderseite des Bauelementgehäuses (2) hin vergrößert, derart, dass auf der Innenfläche (53) auftreffende Strahlung der Schichtenfolge zu einer gewünschten optischen Achse (3) des Bauelements hin gezielt umgelenkt wird, und
- einer bodenseitig dem Reflektorbereich (51) vorgelagerten Substratmulde(52), in der der Strahlung aussendende Körper (1) angeordnet ist, wobei die Tiefe der Substratmulde so gewählt ist, dass das Trägersubstrat zumindest teilweise gegenüber dem Reflektorbereich versenkt ist und die Länge und die Breite der Substrätmulde so an die Länge und die Breite des Körpers angepasst sind, dass zwischen den Flanken des Körpers und der Substratmulde nur geringfügige Spalte bestehen.

Als "Vorderseite" des Bauelementes, bzw. des Bauelementegehäuses wird im Folgenden die Seite des Bauelements, bzw. des Bauelementgehäuses bezeichnet, durch die im Betrieb der Hauptanteil der erzeugten Strahlung emittiert wird. Als "Boden" des Bauelementes, bzw. des Bauelementgehäuses wird die Seite des Bauelementes, bzw. des Bauelementgehäuses bezeichnet, die der Vorderseite gegenüberliegt. Weiterhin wird die Seite des strahlungsemittierenden Körpers, von der im Betrieb ein Hauptteil der Strahlung emittiert wird, als Vorderseite oder Frontseite bezeichnet. Die Rückseite des Körpers ist die Seite, die der Vorderseite gegenüberliegt.

Vorliegend wird unter dem Sachverhalt, dass "nur geringfügige Spalte zwischen den Flanken des Körpers und der Substratmulde bestehen" verstanden, dass die lichten Weiten der Substratmulde zweckmäßig nur geringfügig größer als die lateralen Abmessungen des Chips sind, so dass der Chip zwar beispielsweise noch mit herkömmlichen Hilfsmitteln, wie beispielsweise Pick-and-Place-Geräten in die Substratmulde eingesetzt und montiert werden kann, aber nicht mehr Platz besteht. Bei der Ausführungsform gemäß der vorliegenden Erfindung ist der Abstand der Seitenwände der Substratmulde von den Flanken des Strahlung aussendenden Körpers zwischen etwa 0,05 und 0,3 mm vorzugsweise zwischen 0,1 und 0,15 mm, wobei die Grenzen jeweils eingeschlossen sind. Besonders bevorzugt beträgt die Größe der Spalte ca. 100 µm.

Auf Grund der Form der Reflektorwanne (tiefliegender Boden einer Substratmulde mit an den Chip angepassten Abmessungen und einem in Abstrahlrichtung des strahlungsemittierenden Körpers nachgeordnetem Reflektorbereich) ist es möglich, die Innenflächen des Reflektorbereiches sehr nah an den strahlungsemittierenden Bereich des Körpers, sprich an die strahlungsemittierende Schichtenfolge heranzuführen. Die Seitenwände der Substratmulde müssen lediglich hinreichend nah an den Chipflanken angeordnet sein, eben so, dass nur geringfügige Spalte zwischen den Flanken des Chips und der Substratmulde besteht. Dadurch ist es möglich, die flach aus der Oberfläche des Emitters austretende Strahlung mittels der Reflektorwanne sehr eng am Chip nach vorne zur Abstrahlrichtung hin umzulenken.

Bei einer bevorzugten Ausführungsform weisen die Innenflächen des Reflektorbereiches eine reflektierende Schicht auf, die beispielsweise Silber enthält. Dies erhöht vorteilhafterweise die Reflektivität der Innenflächen. Abhängig vom Wellenlängenbereich der Strahlung, die der Körper aussendet, können auch andere Materialien geeignet sein, die Reflektivität der Innenfläche des Reflektorbereiches zu erhöhen.

Bevorzugt wird ein Dünnfilmleuchtdiodenchip als Strahlungsquelle in das Bauelementgehäuse montiert. Der Dünnfilmleuchtdiodenchip wird hierbei so in der Substratmulde angeordnet, dass sein Trägersubstrat dem Boden des Bauelementgehäuses zugewandt ist.

Die Innenfläche des Reflektorbereiches kann mit Vorteil als Paraboloid ausgebildet sein. Dadurch kann die Wirksamkeit der Reflektorwanne verbessert werden.

Ein Reflektorbereich mit parabolischer Innenfläche lenkt vorliegend insbesondere einen besonders großen Teil der Strahlung, die flach von der Oberfläche des strahlunsemittierenden Körpers austritt, in Richtung der optischen Achse um und ist daher insbesondere geeignet die Strahlung zu bündeln. In dem vorliegenden Zusammenhang bedeutet "flach", dass die Strahlung einen kleinen Winkel α mit der Vorderseite des strahlungsemittierenden Körpers einschließt.

Weiterhin kann die Innenfläche des Reflektorbereiches auch kegelstumpfförmig ausgebildet sein. Gegenüber einer parabolischen Innenfläche ist eine kegelstumpfförmige Innenfläche des Reflektorbereiches einfacher zu realisieren. Weiterhin ist ein Reflektorbereich mit einer kegelstumpfförmigen Innenfläche insbesondere geeignet ein Beleuchtungsfeld mit einer homogenen Strahldichte zu erzeugen.

Bei einer weiteren Ausführungsform weist der Reflektorbereich eine spärische Innenfläche auf. Ein Reflektorbereich mit einer sphärisch geformten Innenfläche ist insbesondere geeignet, Abstrahlwinkel im Bereich zwischen 15° und 30° zu erzielen.

Bei einer Ausführungsform gemäß der vorliegenden Erfindung weist das Bauelementgehäuse eine Linse auf, die vom Boden des Bauelementgehäuses her gesehen, dem Reflektorbereich nachgeordnet ist. Die Linse bewirkt eine Bündelung der direkten Frontstrahlung und der durch den Reflektorbereich reflektierten flachen Oberflächenstrahlung. Mit Hilfe der Linse kann die Abstrahlcharakteristik eines optoelektronischen Bauelementes mit dem Bauelementgehäuse gezielt angepasst werden.

Die Linse kann beispielsweise derart ausgelegt sein, dass gezielt ein gewünschter Öffnungswinkel des Abstrahlkegels des optoelektronischen Bauelementes realisiert wird.

Bei einer Ausführungsform ist die Linse eine asphärische Linse, bevorzugt mit der Form eines Ellipsoid-Segments, da mit Hilfe einer solchen Linse in der Regel auch achsferne Strahlung gut gebündelt werden kann. Unter achsferner Strahlung wird vorliegend Strahlung verstanden, die nicht in direkter Nähe der optischen Achse des optoelektronischen Bauelementes verläuft. Dies ermöglicht im Vergleich zu sphärischen Linsen eine weitere Verringerung der Linsenabmessungen.

Es ist jedoch auch denkbar, dass die Linse eine andere Form aufweist, beispielsweise eine, die durch Rotation einer beliebigen Kurve um die optische Achse entsteht. Vorteilhafterweise werden Linsenform und die Form des Reflektorbereiches so aneinander angepasst, dass die von dem Bauelement emittierte Strahlung in dem gewünschten Winkelbereich homogen abgestrahlt wird, so dass ein homogen ausgeleuchtetes Beleuchtungsfeld mit definierten Abmessungen entsteht.

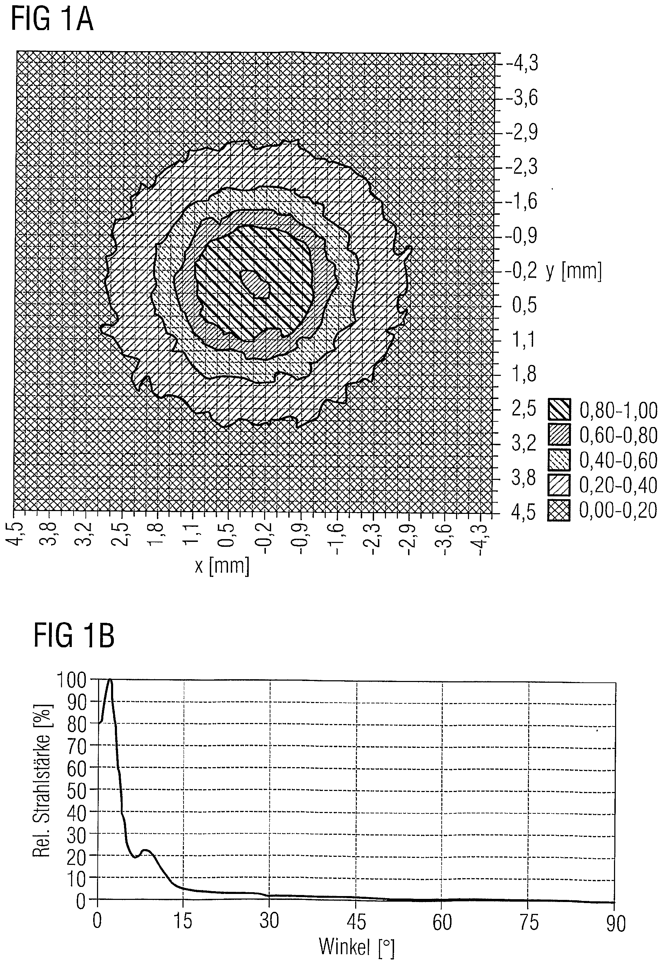

Die Kombination aus der Reflektorwanne gemäß der Erfindung und einer asphärischen Linse erlaubt eine sehr homogene Ausleuchtung einer sehr kleinen Fläche im Nahfeld mit hoher Bestrahlungsstärke. Man vergleiche hierzu die laterale Verteilung der simulierten Werte der relativen Strahlstärke (in %) eines Bauelementes mit aspärischer Linse und einem Reflektorbereich mit kegelstumpfförmiger Innenfläche in 2 mm Abstand zur Linse in Figur 1A. Unter "relativer Strahlstärke" wird die Strahlstärke verstanden, die auf den maximalen Wert der Strahlstärke normiert ist. In dem Diagramm der Figur 1B ist weiterhin auf der x-Achse der halbe Öffnungswinkel des Abstrahlkegels in Grad und an der y-Achse die relative Strahlstärke entsprechend Figur 1A aufgetragen.

Wie Figur 1B zu entnehmen, kann mit der Kombination aus einer Linse und einem Reflektorbereich mit kegelstumpfförmiger Innenfläche ein Halbwinkel von 8,4° erzielt werden. Unter Halbwinkel wird der Öffnungswinkel des Abstrahlkegels verstanden, bei dem die Strahlstärke 50% des Wertes an der Vorderseite des Strahlung emittierenden Körpers beträgt. Der Aufbau und die anschließenden Messungen zeigen, daß ein Halbwinkel von 7° und eine Strahlstärke Ie von 46mW/sr (20mA), sowie eine Strahlungsleistung PhiE von 7,6mW (20mA) realisiert werden können.

Bei einer weiteren Ausführungsform handelt es sich bei der Linse um eine Fresnellinse. Eine Fresnellinse ermöglicht vorteilhafterweise eine sehr flache Bauform des Baugehäuses bzw. des Bauelementes.

Weiterhin kann die Linse auch die Form eines nicht-rotationssymmetrischen Ellipsoid-Segmentes aufweisen. Unter einem nicht-rotationssymmetrischen Ellipsoid-Segment wird vorliegend ein Segement eines Ellipsoids verstanden, dessen drei Achsen unterschiedliche Länge aufweisen und das daher nicht durch Rotation einer Kurve um die optische Achse erzeugt werden kann. Mit Hilfe einer solchen Linse kann ein Beleuchtungsfeld mit asymmetrischer Form, insbesondere mit elliptischer Form, erzielt werden. Bauelemente mit einer Linse der Form eines nicht-rotationssymmetrischen Ellipsoid-Segmentes finden bevorzugt Anwendung in Großdisplays für Stadien oder Bahnhöfe.

Durch das Zusammenspiel einer Linse und einer Reflektorwanne ist es möglich, nahezu die gesamte Frontstrahlung eines oberflächenemittierenden Strahlungsquellen-Körpers, wie beispielsweise eines Dünnfilm-Leuchtdiodenchips, in ein sehr enges, homogen ausgeleuchtetes Bestrahlungsfeld zu leiten.

Die vorliegende Reflektorwanne ist hierbei geeignet, einen möglichst großen Teil der Strahlung, die von der Oberfläche des Körpers ausgesendet wird, derart zu bündeln, dass sie von der nachgeordneten Linse in einem Abstrahlkegel mit einem definierten Öffnungswinkel abgestrahlt wird. Bei einer bevorzugten Ausführungsform ist der Öffnungswinkel des Abstrahlkegels möglichst gering, so dass die Strahlung im Wesentlichen parallel zu optischen Achse des Bauelementes ausgesendet wird.

Solche eng abstrahlenden und hellen Leuchtdiodenbauelemente werden häufig und bevorzugt zur gleichmäßigen Bestrahlung kleinerer Flächen eingesetzt, wie z. B. in einer optischen Computer-Mouse. Weiterhin sind Leuchtdiodenbauelemente, die Strahlung aus dem infraroten Wellenlängenbereich in Form eines Abstrahlkegels mit geringem Öffnungswinkel und im Wesentlichen gleichmäßiger, hoher Intensität emittieren, insbesondere zum Einsatz in Lichtschranken, sowie Feedbacksensoren in Druckern zur Justage der Druckköpfe und Ermittlung der Papierbeschaffenheit geeignet. Eine weitere bevorzugte Anwendung der vorliegenden Leuchtdiodenbauelemente stellt die Datenübertragung bei Multimediaanwendungen in Kraftfahrzeugen dar.

Bei der Ausführungform der Erfindung umfasst das Bauelementgehäuse weiterhin einen kegelstumpfartigen Sockelbereich, an den sich die Linse anschließt. Die Linse ist gegenüber dem Sockel zurückspringen, so dass eine Schulter ausgebildet wird. Insbesondere bei einem so genannten Leuchtdiodenbauelement in Radial-Bauform ist der Übergang der Linse in den restlichen Gehäusekörper, bzw. in den Sockelbereich, als Stufe ausgebildet. Unter Radial-Bauform wird eine Bauform des Bauelementes verstanden, die im Wesentlichen rotationssymmetrisch zur optischen Achse des Bauelementes ist. Dadurch läßt sich auf einfache Weise ein gegenüber dem Durchmesser des restlichen Gehäusekörpers kleinerer Linsendurchmesser realisieren. Eine Linse, deren Durchmesser kleiner ist als die Abmessungen des restlichen Gehäusekörpers, kann auch bei nicht radialen Bauformen eingesetzt werden.

Bevorzugt ist die Substratmulde kegelstumpfartig geformt, so dass sich ihr Querschnitt von deren Boden zum Reflektorbereich hin vergrößert. Eine solche Form ermöglicht die Herstellung der Reflektorwanne mittels Prägen aus dem Leadframe, da das Prägewerkzeug besser entformt werden kann. Besonders bevorzugt schließen die Seitenwände der Substratmulde mit der Flächennormalen des Bodens der Substratmulde einen Winkel β von etwa 1° ein.

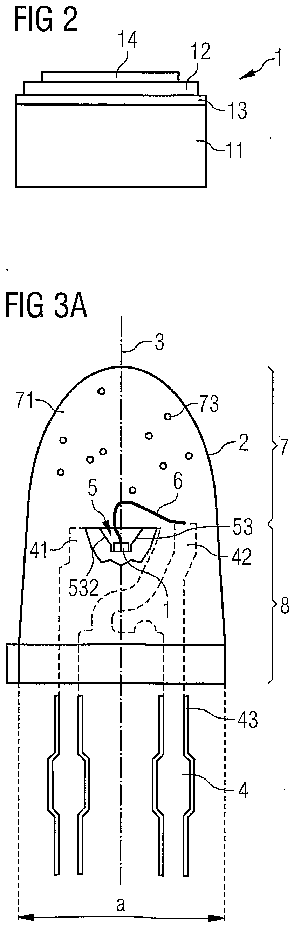

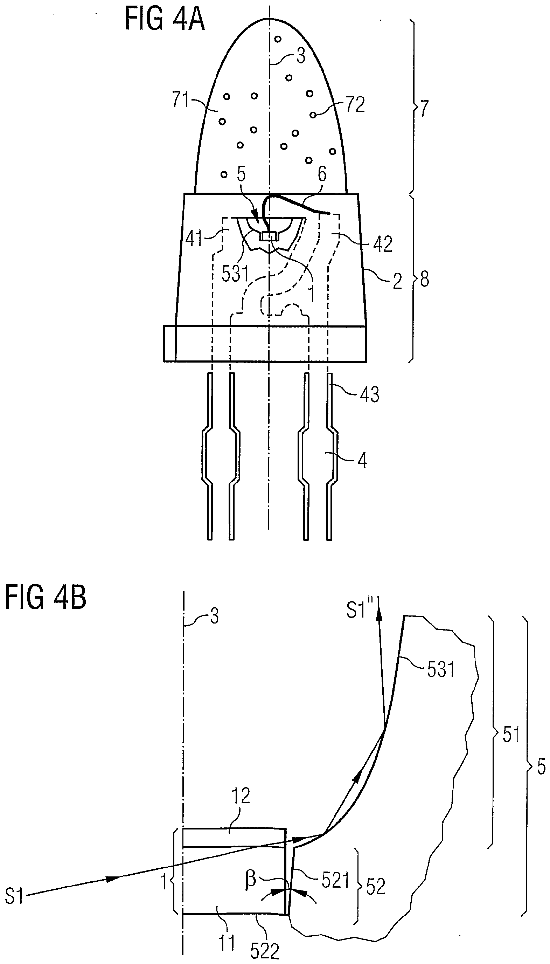

Weitere Ausführungen, Weiterbildungen und Vorteile der Erfindung werden im Folgenden anhand dreier Ausführungsbeispiele in Verbindung mit den Figuren 2, 3A bis 3C, 4A und 4B, 5A bis 5D und 6A und 6B näher erläutert, wobei nur der Ausführungsbeispiel nach Figur 4A ein Ausführungsbeispiel gemäß der Erfindung wie beansprucht repräsentiert.

Es zeigen:
Figur 1A, simulierte Werte der relativen Strahlstärke in % eines Bauelementes;
Figur 1B, Winkelverteilung der simulierten Werte der relativen Strahlstärke aus Figur 1B;
Figur 2, eine schematische Schnittdarstellung eines DünnfilmHalbleiterchips;
Figur 3A, eine schematische Schnittdarstellung eines Bauelementes gemäß einem ersten Ausführungsbeispiel;
Figur 3B, eine gegenüber Figur 3A vergrößerte schematische Schnittdarstellung der Reflektorwanne des ersten Ausführungsbeispiel;
Figur 3C, eine schematische Schnittdarstellung einer Teilvergrößerung einer Reflektorwanne, die den Einfluss des Reflektorbereiches gemäß dem ersten Ausführungsbeispiel auf den Verlauf von Strahlung darstellt, die einen kleinen Winkel α mit der strahlungsemittierenden Oberfläche des DünnfilmHalbleiterchips einschließt;
Figur 4A, eine schematische Schnittdarstellung eines Bauelementes gemäß einem zweiten Ausführungsbeispiel, gemäß der Erfindung wie beansprucht.
Figur 4B, eine schematische Schnittdarstellung einer Teilvergrößerung einer Reflektorwanne, die den Einfluss des Reflektorbereiches gemäß dem zweiten Ausführungsbeispiel auf den Verlauf von Strahlung darstellt, die einen kleinen Winkel α mit der strahlungsemittierenden Oberfläche des DünnfilmHalbleiterchips einschließt;
Figur 5A, eine schematische Schnittdarstellung des Bauelementes gemäß dem ersten Ausführungsbeispiel mit Darstellung des Strahlenverlaufs einer "steil" emittierten frontseitigen Oberflächenstrahlung des Dünnfilm-Leuchtdiodenchips, die nicht vom Reflektorbereich umgelenkt wird;
Figur 5B, eine schematische Schnittdarstellung des Bauelementes gemäß dem ersten Ausführungsbeispiel mit Darstellung des Strahlenverlaufs einer "flach" emittierten frontseitigen Oberflächenstrahlung des Dünnfilm-Leuchtdiodenchips, die vom Reflektorbereich zur optischen Achse des Bauelements hin umgelenkt wird;
Figur 5C, eine schematische Schnittdarstellung des Bauelementes gemäß dem ersten Ausführungsbeispiel mit Darstellung des Strahlenverlaufs einer seitlich durch die Chipflanken emittierten Strahlung des Dünnfilm-Leuchtdiodenchips, die vom Reflektorbereich zur optischen Achse des Bauelements hin umgelenkt wird;
Figur 5D, eine schematische Schnittdarstellung der Linse und des Reflektorbereiches gemäß dem ersten Ausführungsbeispiel mit dem Strahlenverlauf für alle Abstrahlrichtungen des Chips;
Figur 6A, eine schematische Schnittdarstellung der Linse und des Reflektorbereiches gemäß einem dritten Ausführungsbeispiel mit dem Strahlenverlauf in der xz-Ebene; und
Figur 6B, eine schematische Schnittdarstellung der Linse und des Reflektorbereiches gemäß einem dritten Ausführungsbeispiel mit dem Strahlenverlauf in der yz-Ebene.

Der Dünnfilm-Leuchtdiodenchip 1 gemäß Figur 2 weist beispielsweise einen aktiven Dünnfilm-Schichtenstapel 12, insbesondere auf der Basis von In_{l-x-y}AlₓGa_{yP} (wobei 0≤x≤1, 0≤y≤1 und x+y≤1 ist) auf, in der eine Photonen emittierende Zone ausgebildet ist und ein Trägersubstrat 11 für den Dünnfilmschichtenstapel 12, das an einer von der Abstrahlrichtung des Chips 1 abgewandten Seite des Dünnfilm-Schichtenstapels 12 angeordnet und mit dieser verbunden ist. Solche Leuchtdiodenchips 1 sind dem Fachmann auf dem Gebiet der Leuchtdiodentechnik bekannt und werden von daher an dieser Stelle nicht näher erläutert.

Dünnfilmschichtenstapel 12 auf der Basis von In_{l-x-y}AlₓGa_{y}P (wobei 0≤x≤1, 0≤y≤1 und x+y≤1 ist) bedeutet, dass der Dünnfilm-Schichtenstapel 12 eine Mehrzahl von Schichten aufweist, die aus dotiertem oder undotiertem Material aus dem System In_{l-x-y}AlₓGa_{y}P (wobei 0≤x≤1, 0≤y≤1 und x+y≤1 ist) hergestellt sind.

Der Dünnfilmschichtenstapel 12 kann weiterhin auch auf In_{1-x-y}AlₓGa_{y}N ( mit 0≤x≤1, 0≤y≤1 und x+y≤1) oder In_{l-x-y}AlₓGa_{y}As (mit 0≤x≤1, 0≤y≤1 und x+y≤1) basieren. Basierend auf In_{l-x-y}AlₓGa_{y}N (mit 0≤x≤1, 0≤y≤1 und x+y≤1), bzw. In_{l-x-y}AlₓGa_{y}As (mit 0≤x≤1, 0≤y≤1 und x+y≤1) bedeutet, äquivalent zu "basierend auf In_{l-x-y}AlₓGa_{y}P", dass der Dünnfilm-Schichtenstapel 12 eine Mehrzahl von Schichten aufweist, die aus dotiertem oder undotiertem Material aus dem System In_{l-x-y}AlₓGa_{y}N (mit 0≤x≤1, 0≤y≤1 und x+y≤1), bzw. In_{l-x-y}AlₓGa_{y}As (mit 0≤x≤1, 0≤y≤1 und x+y≤1) hergestellt sind.

Der Dünnfilmschichtenstapel 12 umfasst weiterhin einen Bereich, der geeignet ist, Photonen zu erzeugen, wie beispielsweise einen pn-Übergang, Einfach- oder Mehrfachquantentöpfe. Eine geeigneter, auf InGaN-basierende Dünnfilmschichtenstapel 12 ist beispielsweise in der WO 01/39282 A2 beschrieben, deren Offenbarungsgehalt diesbezüglich hiermit durch Rückbezug aufgenommen wird.

Das Trägersubstrat 11 ist Teil des Halbleiterchips 1 an sich und mechanische Stütze für den Dünnfilm-Schichtenstapel 12, d. h. das wesentliche tragende Element für den DünnfilmSchichtenstapel 12, der selbst auf der dem Trägersubstrat 11 gegenüberliegenden Seite keine selbsttragende Schicht mehr aufweist. Zwischen Trägersubstrat 11 und DünnfilmSchichtenstapel 12 ist ein reflektierendes Element 13 angeordnet, beispielsweise eine reflektierende Schicht oder Schichtenfolge, die Strahlung aus dem DünnfilmSchichtenstapel 12 zur strahlungsemittierenden Vorderseite des Halbleiterchips 1 reflektiert. Vorliegend ist das Trägersubstrat 11 und das reflektierende Element 13 elektrisch leitfähig, so dass der Dünnfilmhalbleiterchip 1 rückseitig über das Trägersubstrat 11 elektrisch kontaktiert werden kann. Zur elektrischen Kontaktierung der Vorderseite ist auf dem Dünnfilmschichtenstapel 12 eine elektrisch leitfähige Kontaktschicht 14 ausgebildet. Weiterhin ist es auch denkbar, beispielsweise wenn das Trägersubstrat 11 elektrisch isolierend ist, dass sich auf dem Dünnfilmschichtenstapel 12 vorderseitig zwei getrennte elektrische Kontakte befinden, über die der Dünnfilmhalbleiterchip 1 jeweils mit einem Bonddraht zu den Anschlussteilen 41, 42 des Leadframes 4 elektrisch leitend verbunden wird (nicht dargestellt). Ausführungsformen von Dünnfilmhalbleiterchips 1 mit zwei vorderseitigen Kontakten sind dem Fachmann bekannt und werden daher an dieser Stelle nicht näher erläutert.

Bei den beiden Ausführungsbeispielen gemäß den Figuren 3A bis 3C, sowie 4A und 4B handelt es sich um eine so genannte 5 mm Radial-Bauform mit Vorteil zum Einsatz in einer optischen Computer-Mouse zur Ausleuchtung der zu detektierenden Mouse-Unterlage.

Bei einer 5 mm Radial-Bauform handelt es sich um ein Bauelement mit einem Bauelementgehäuse 2, das eine zu einer optischen Achse 3 des Bauelementes im Wesentlichen rotationssymmetrische Form aufweist und dessen äußerster Durchmesser a 5 mm beträgt. Es sind auch Radial-Bauformen möglich, bei denen der Durchmesser a kleiner oder größer ist und beispielsweise 3 mm oder 11 mm beträgt.

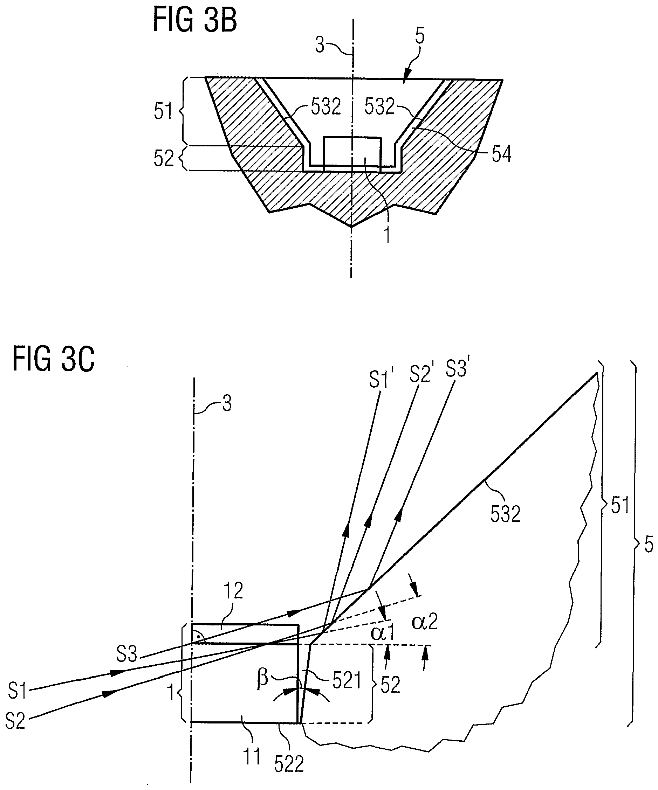

Das Bauelementgehäuse 2 umfasst einen Leadframe 4 mit elektrischen Anschlussteilen 41, 42 und einer Reflektorwanne 5. Die Reflektorwanne 5 weist einen trichterartig geformten Reflektorbereich 51 und eine dem Reflektorbereich 51 bodenseitig vorgelagerte Substratmulde 52 auf. Die Innenfläche 53 des Reflektorbereiches 51 kann, wie in den Figuren 3A, 3B und 3C gezeigt, kegelstumpfartig ausgebildet oder, wie in den Figuren 4A und 4B gezeigt, parabolisch geformt sein.

Der Leadframe 4 ist bis auf die Reflektorwanne 5 aus einem Blech herausgestanzt. Die Reflektorwanne 5 ist mit einem Prägewerkzeug, das die inverse gewünschte Form hat, beispielsweise mit parabolischer oder kegelstumpfförmiger Innenfläche des Reflektorbereiches 51 mit bodenseitig vorgelagerter Substratmulde 52, in den Leadframe 4 geprägt. Die Substratmulde 52 ist hierbei bevorzugt kegelstumpfförmig ausgebildet, da die schrägen Seitenwände die Entformung des Prägewerkzeuges erleichtern. Als Material für den Leadframe 4 kann beispielsweise eine Legierung verwendet werden, die CuFe umfasst. Um die Reflektivität des Reflektorbereiches 51 zu erhöhen, ist zumindest dieser mit einer Silberschicht 54 versehen. Die Silberschicht 54 kann beispielsweise galvanisch aufgebracht werden.

Der strahlungsemittierende Dünnfilmchip 1, wie er beispielsweise in Figur 2 gezeigt ist, ist in die Substratmulde 52 montiert, beispielsweise geklebt. Die elektrische Kontaktierung des Dünnfilmchips 1 hängt von der geometrischen Anordnung seiner Kontakte ab. Befindet sich beispielsweise einer der elektrischen Kontakte an der Rückseite der Dünnfilmhalbleiterchips 1 und ein Kontakt an der Vorderseite des Dünnfilmhalbleiterchips 1, so wird der rückseitige Kontakt beispielsweise durch Verwendung eines elektrisch leitfähigen Klebers mittels Die-Bonden mit dem Leadframe 4 und die Vorderseite durch einen Bonddraht 6 zu dem elektrischen Anschlussteil 42 des Leadframes 4 elektrisch leitfähig verbunden. Der Bonddraht 6 umfasst vorliegend Gold und formt in Anschluss an den Chip 1 eine kugelförmige Verbindung (ball) und in Anschluss an den Leadframe eine Kante (wedge) aus. Ball-Wedge-Bondverbindungen sind dem Fachmann bekannt und werden daher an dieser Stelle nicht näher erläutert.

Weist der Dünnfilmhalbleiterchip 1 beide elektrischen Kontakte an der Vorderseite auf (nicht dargestellt), so kann der Dünnfilmhalbleiterchip 1 auch mit einem elektrisch isolierenden Kleber in der Substratmulde 52 befestigt werden und die beiden Kontakte jeweils mit einem Bonddraht 6 mit den Anschlussteilen 41, 42 des Leadframes elektrisch leitend verbunden werden.

Damit die Bereiche der elektrischen Anschlussteile 41, 42 des Leadframes 4, die aus dem Bauelementgehäuse 2 herausragen, gelötet werden können, sind diese Bereiche vorliegend galvanisch mit einer Schicht 43 überzogen, die Zinn enthält.

Der Reflektorbereich 51 wirkt hauptsächlich am strahlungserzeugenden Dünnfilm-Schichtenstapel 12. Der eigentliche strahlungsemittierende Bereich des Dünnfilmchips 1 ist nur wenige µm dick und auf einem vergleichsweise dicken Trägersubstrat 11, vorliegend 180 µm dick, aufgebracht. Zwischen dem Trägersubstrat 11 und dem Dünnfilm-Schichtenstapel 12 ist die reflektierende Schicht 13 angeordnet, derart, dass nahezu keine Strahlung in das Trägersubstrat 11 eindringen kann, sondern von der reflektierenden Schicht 13 weitgehend nach vorne oder zur Seite reflektiert wird.

Um die Seitenstrahlung und die flach von der Vorderseite des Chips 1 ausgesandte Strahlung effizient nach vorne zu reflektieren, ist die Reflektorwanne 5 sehr eng am DünnfilmSchichtenstapel 12 angeordnet. Dies wird durch die Substratmulde 52 der Reflektorwanne 5, in der der Dünnfilm-Chip 1 teilweise versenkt wird, ermöglicht. Vorliegend wurde die Tiefe der Substratmulde 52 mit 160 µm geringfügig geringer gewählt als die Dicke des Trägersubstrats 11 (180 µm), so dass eine über die Flanken der Dünnfilm-Schichtenfolge 12 seitlich leicht schräg nach hinten emittierte Strahlung ebenfalls noch auf den Reflektorbereich 51 trifft. Das hinsichtlich Strahlungsemission nicht funktionale Trägersubstrat 11 befindet sich folglich effektiv nicht im Wirkungsbereich des eigentlichen Reflektorbereiches 51.

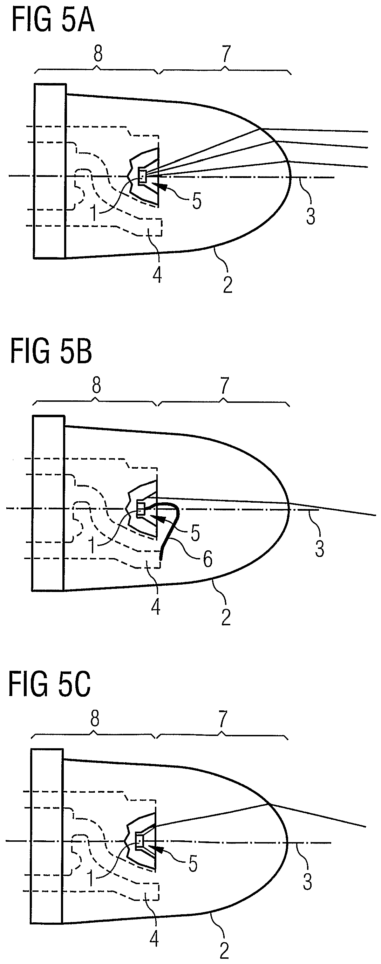

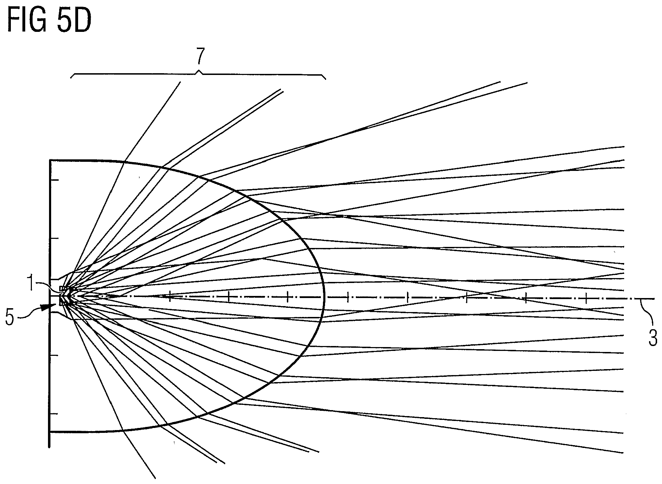

Der Reflektorbereich 51 wirkt nun direkt in geringem Abstand an der strahlungserzeugenden Schicht des Chips 1 und kann effizient die flach aus der Oberfläche des Chips 1 austretende Strahlung, dass heißt Strahlung, die einen kleinen Winkel α mit der strahlungsemittierenden Oberfläche des Chips 1 einschließt, und auch die Seitenstrahlung (durch die Chipflanken) in Richtung optische Achse 3 umlenken (vergleiche Figuren 3C und 5B). Strahlung, die seitliche über die Flanken des Chips 1 emittiert wird, wird ebenfalls durch den Reflektorbereich 51 in Richtung der optischen Achse 3 umgelenkt (vergleiche Figuren 3C und 5C).

Im Unterschied zu dem ersten Ausführungsbeispiel gemäß den Figuren 3A bis 3C, weist das Bauelement des zweiten Ausführungsbeispiels gemäß der Figur 4A und 4B einen Reflektorbereich 51 mit parabolischer Innenfläche 531 auf. Wie anhand der Figur 4B zu sehen ist, reflektiert eine parabolische Innenfläche 531 Strahlung, die einen kleinen Winkel α mit der strahlungsemittierenden Oberfläche des Chips 1 einschließt, ggf. mehrfach und lenkt diese dadurch stärker in Richtung der optischen Achse 3 (vergleiche den an der parabolischen Innenfläche 531 reflektierten Strahl S1" mit dem an der kegelstumpfförmigen Innenfläche 532 reflektierten Strahl S1' der Figur 3C).

Die Seitenwände 521 der Substratmulde 52 schließen mit der Normalen der Bodenfläche 522 der Substratmulde 52 einen Winkel β von etwa 1° ein. Der Abstand der Seitenwände 521 von den Flanken des Dünnfilm-Chips 1 beträgt etwa 0,05 bis 0,3 mm, vorzugsweise 0,1 bis 0,15 mm.

Als zweites optisches Element kommt eine asphärische Linse 7 zum Einsatz. Diese ist der Reflektorwanne 5 und dem DünnfilmChip 1 in Richtung der Vorderseite des Bauelements nachgeordnet und befindet sich auf einem kegelstumpfartigen Sockelbereich 8, der den Chip 1 und die Reflektorwanne 5 umhüllt. Die Linse 7 ist derart geformt, dass achsnahe Strahlung parallelisiert wird und die vom Reflektorbereich 52 umgelenkte Strahlung stärker in Richtung optische Achse 3 gebrochen wird und so im Zentrum des Strahlungsfeldes des Bauelements zur Wirkung kommt (vergleiche Figuren 5A bis 5D).

Vorliegend weist die Linse 7 eine elliptische Form auf, so dass auch achsferne Strahlen so zur optischen Achse 3 gebrochen werden, dass ein überwiegender Teil der vom Halbleiterchip 1 entsandten Strahlung in einen begrenzten Bereich gebündelt wird.

Zur Herstellung der Linse 7 wird der Leadframe 4 mit dem montierten und elektrisch kontaktierten Chip 1 in einer Form positioniert, die die Negativform der gewünschten Linse 7 und des angrenzenden Sockelbereiches 8 aufweist und mit einer geeigneten Vergussmasse 71, wie beispielsweise einem Epoxydharz, vergossen. Um zu vermeiden, dass sich hierbei eine Luftblase in der Reflektorwanne 5 ausbildet, wird die Reflektorwanne 5 vor dem Vergießen in der Form mit der Vergussmasse 71 benetzt, beispielsweise durch einen gesonderten Schritt, bei dem die Reflektorwanne 5 in die Vergussmasse 71 eingetaucht wird. Die Linse 7 kann so an den Sockelbereich 8 angrenzen, dass sie tangential in den Sockelbereich 8 übergeht (vergleiche beispielsweise Figur 3A) oder gegenüber dem Sockelbereich 8 zurückspringt, so dass eine Schulter ausgebildet wird (vergleiche beispielsweise Figur 4A). Im letzteren Fall können auch Linsen 7 verwendet werden, deren Durchmesser nicht an den Durchmesser des Sockelbereiches 8 angepasst ist.

Weiterhin ist es denkbar, dass die Vergussmasse 71 Pigmente 72 enthält, die den gewünschten Farbeindruck des optoelektronischen Bauelementes erzeugen oder zumindest unterstützten (vergleiche Figur 4A). Anstelle von Pigmenten 72, die den unerwünschten Anteil der von dem Chip 1 emittierten Strahlung absorbieren, ist es auch denkbar, Lumineszenzkonversionsstoffe 73 in die Vergussmasse 71 einzubringen, die einen bestimmten Spektralbereich der vom Chip emittierten Strahlung absorbieren und in Strahlung einer anderen, in der Regel größeren, Wellenlängen umwandeln und wieder emittieren (vergleiche Figur 3A) .

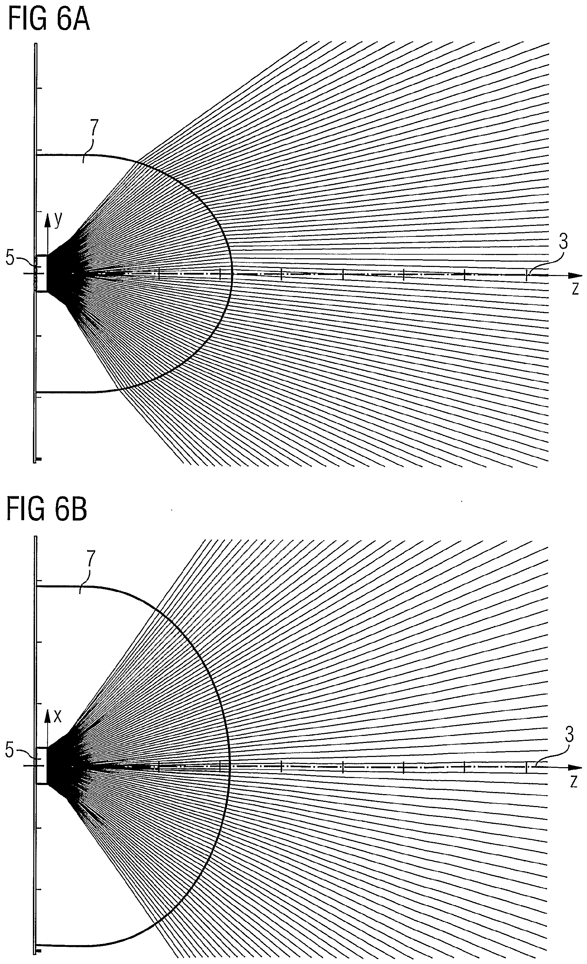

Im Unterschied zu den oben beschriebenen Ausführungsbeispielen weist bei dem Ausführungsbeispiel gemäß der Figuren 6A und 6B die Linse 7 des Bauelementes die Form eines nicht-rotationssymmetrischen Ellipsoid-Segmentes auf, das im Unterschied zu einem rotationssymmetrischen Ellipsoid-Segment zwei unterschiedlich lange Halbachsen in x- und y-Richtung aufweist. Vorliegend wird die optische Achse 3 als z-Achse bezeichnet, während die x-Achse und die y-Achse jeweils senkrecht zur z-Achse eine Ebene aufspannen, die die Bodenfläche 522 der Substratmulde 52 beinhaltet. Der Schnittpunkt der x-Achse, der y-Achse und der z-Achse befindet sich im Mittelpunkt der Bodenfläche 522 der Substratmulde 52.

Die Linse 7 weist gemäß dem vorliegenden Ausführungsbeispiel eine kürzere Halbachse in x-Richtung als in y-Richtung auf, so dass der Öffnungswinkel des Abstrahlkegels in der xz-Ebene (vergleiche Figur 6A) kleiner ist als der Öffnungswinkel des Abstrahlkegels in der yz-Ebene (vergleiche Figur 6B) und so ein asymmetrisches Beleuchtungsfeld entsteht.

Die Erfindung ist selbstverständlich nicht durch die beispielhafte Beschreibung anhand der Ausführungsbeispiele auf diese beschränkt. Vielmehr umfasst die Erfindung jede Kombination von Merkmalen gemäß den Patentansprüchen.

## Patentansprüche

1. Optoelektronisches Bauelement mit einem Körper (1), der geeignet ist, im Betrieb des Bauelements elektromagnetische Strahlung auszusenden, der ein Trägersubstrat (11) und eine auf diesem Trägersubstrat (11) angeordnete Strahlung aussendende Schichtenfolge (12) umfasst und der in einer Reflektorwanne (5) eines Bauelementgehäuses (2) angeordnet ist und mit externen elektrischen Anschlussleitern (41,42) des Bauelementgehäuses (2) elektrisch leitend verbunden ist, wobei die Reflektorwanne (5) umfasst:
- einen Reflektorbereich (51) mit einer Innenfläche (53), dessen Querschnitt sich gesehen vom Strahlung emittierenden Körper (1) zu einer Vorderseite des Bauelementgehäuses (2) hin vergrößert, derart, dass auf der Innenfläche (53) auftreffende Strahlung der Schichtenfolge zu einer gewünschten optischen Achse (3) des Bauelements hin gezielt umgelenkt wird;
- eine bodenseitig dem Reflektorbereich (51) vorgelagerte Substratmulde(52), in der der Strahlung aussendende Körper (1) angeordnet ist, wobei die Tiefe der Substratmulde (52) so gewählt ist, dass das Trägersubstrat (11) zumindest teilweise gegenüber dem Reflektorbereich (51) versenkt ist und die Länge und die Breite der Substratmulde (52) so an die Länge und die Breite des Körpers (1) angepasst sind, dass ein Abstand der Seitenwände der Substratmulde von den Flanken des Strahlung emittierenden Körpers zwischen 0,05 mm und 0,3 mm liegt;
**dadurch gekennzeichnet dass** das Bauelementgehäuse (2) eine Sockelbereich (8) umfasst, an den sich die Linse (7) anschließt, wobei die Reflektorwanne gegenüber der Vorderseite des Bauelementgehäuses zurückgesetzt ist und
die Linse (7) derart gegenüber dem Sockelbereich (8) zurückspringt, dass eine Schulter ausgebildet wird.

2. Optoelektronisches Bauelement nach Anspruch 1, **dadurch gekennzeichnet, dass**
das Bauelementgehäuse (2) eine Linse (7) aufweist, durch die die optische Achse (3) verläuft und die im Bereich, in dem die optische Achse (3) die Oberfläche der Linse (7) schneidet, den kleinsten und mit zunehmendem Abstand von der optischen Achse (3) immer größer werdenden Krümmungsradius aufweist.

3. Optoelektronisches Bauelement nach Anspruch 2, **dadurch gekennzeichnet, dass**
die Linse (7) eine Fresnellinse ist.

4. Optoelektronisches Bauelement nach Anspruch 2, **dadurch gekennzeichnet,**
**dass** die Linse eine asphärische Linse mit der Form eines Ellipsoid-Segments ist.

5. Optoelektronisches Bauelement nach Anspruch 2, **dadurch gekennzeichnet,**
**dass** die Linse ein nicht-rotationssymmetrisches Ellipsoid-Segment aufweist.

6. Optoelektronisches Bauelement nach einem der Ansprüche 1 bis 5,
**dadurch gekennzeichnet, dass**
Seitenwände (521) der Substratmulde (52) mit der Normalen einer Bodenfläche (522) der Substratmulde (52) einen Winkel β von etwa 1° einschließen.

7. Optoelektronisches Bauelement nach einem der obigen Ansprüche
**dadurch gekennzeichnet, dass**
die Innenfläche (53) des Reflektorbereiches (51) eine Schicht (54) aufweist, die die Reflektivität der Innenfläche (53) erhöht.

8. Optoelektronisches Bauelement nach Anspruch 7 **dadurch gekennzeichnet, dass**
die Schicht (54) Silber aufweist.

9. Optoelektronisches Bauelement nach einem der obigen Ansprüche
**dadurch gekennzeichnet, dass**
die Innenfläche (53) des Reflektorbereiches (51) parabolisch, kegelstumpfförmig oder sphärisch ausgebildet ist.

10. Verwendung eines optoelektronischen Bauelementes nach einem der obigen Ansprüche
**dadurch gekennzeichnet, dass**
es in einer Computer-Mouse, einer Lichtschranke oder einem Drucker eingesetzt wird.

## Claims

1. Optoelectronic device with a body (1) which is suitable to send out electromagnetic radiation under operation of the device, comprising a carrier substrate (11) and a layer sequence (12) arranged on this carrier substrate (11) and emitting radiation, and which is located in a reflector trough (5) of a device housing (2) and electrically conductively connected to external electrical connector conductors (41, 42) of the device housing (2),
wherein
the reflector trough (5) comprises:
- a reflector region (51) with an inner surface (53) the cross section of which, seen from the body (1) emitting radiation, enlarges in the direction of a front side of the device housing (2) in such a way that radiation of the layer sequence impinging on the inner surface (53) is deflected in a targeted way in the direction of a desired optical axis (3) of the device;
- a substrate depression (52) arranged in front of the reflector region on the bottom side in which the body (1) emitting radiation is arranged, wherein the depth of the substrate depression (52) is selected in such a way that the carrier substrate (11) is at least partially recessed with respect to the reflector region and the length and the width of the substrate depression (52) are adapted to the length and the width of the body (1) in such a way that a distance of the side walls of the substrate depression from the flanks of the body emitting radiation is between 0.05 mm and 0.3 mm;
**characterized in**
**that** the device housing (2) comprises a base region (8) to which the lens (7) adjoins, wherein the reflector trough is set back with respect to the front side of the device housing and
the lens (7) is offset back with respect to the base region (8) in such a way that a shoulder is formed.

2. Optoelectronic device according to claim 1,
**characterized in that**
the device housing (2) has a lens (7) through which the optical axis (3) runs and which, in the region in which the optical axis intersects the surface of the lens (7), has the smallest radius of curvature which becomes greater with increasing distance from the optical axis (3).

3. Optoelectronic device according to claim 2,
**characterized in that**
the lens (7) is a Fresnel lens.

4. Optoelectronic device according to claim 2,
**characterized in that**
the lens is an aspherical lens with the form of an ellipsoid segment.

5. Optoelectronic device according to claim 2,
**characterized in that**
the lens has an ellipsoid segment which is not rotationally symmetrical.

6. Optoelectronic device according to any one of claims 1 to 5,
**characterized in that**
side walls (521) of the substrate depression (52) enclose an angle β of approximately 1° with the normal of a bottom surface (522) of the substrate depression (52).

7. Optoelectronic device according to one of the preceding claims
**characterized in that**
the inner surface (53) of the reflector region (51) has a layer (54) which increases the reflectivity of the inner surface (53).

8. Optoelectronic device according to claim 7,
**characterized in that**
the layer (54) includes silver.

9. Optoelectronic device according to one of the preceding claims
**characterized in that**
the inner surface (53) of the reflector region (51) is designed parabolically, frustoconically or spherically.

10. Use of a device according to one of the preceding claims
**characterized in that**
it is employed in a computer mouse, a light barrier or a printer.

## Revendications

1. Composant optoélectronique comportant un corps (1) apte à émettre un rayonnement électromagnétique pendant le fonctionnement du composant qui comprend un substrat porteur (11) et une séquence de couche (12) émettant un rayonnement et disposé sur ce substrat porteur (11) et qui est disposé dans un creux de réflecteur (5) d'un boîtier de composant (2) et est connecté électriquement de manière conductrice à des conducteurs de connexion électrique externes (41,42) du boîtier de composant (2),
dans lequel
le creux de réflecteur (5) comprend :
- une région de réflecteur (51) ayant une surface interne (53) dont la section transversale augmente lorsque vue depuis le corps émetteur de rayonnement (1) vers un côté avant du boîtier de composant (2), si bien que le rayonnement de la séquence de couches frappant la surface interne (53) est dévié de manière ciblée vers un axe optique (3) voulu du composant ;
- un évidement de substrat (52) disposé devant la région de réflecteur (51) sur le côté inférieur dans lequel le corps émetteur de rayonnement (1) est arrangé, la profondeur de l'évidement de substrat (52) étant choisie de sorte que le substrat porteur (11) soit au moins partiellement fraisé en face de la région de réflecteur (51), et la longueur et la largeur de l'évidement de substrat (52) sont adaptées à la longueur et à la largeur du corps (1) de telle sorte qu'il subsiste un écart entre les flancs du corps émetteur de rayonnement compris entre 0,05 mm et 0,3 mm ;
**caractérisé en ce que**
le boîtier de composant (2) présente une région de base (8) à laquelle la lentille (7) est adjacente, le creux de réflecteur étant reculé par rapport au côté avant du boîtier de composant, et
la lentille (7) est décalée par rapport à la région de base (8) de façon à former un épaulement.

2. Composant optoélectronique selon la revendication 1,
**caractérisé en ce que**
le boîtier de composant (2) comprend une lentille (7) traversée par l'axe optique (3) et qui, dans la région où l'axe optique (3) coupe la surface de la lentille (7), comporte le plus petit rayon de courbure qui par une distance croissante de l'axe optique (3) continue d'augmenter.

3. Composant optoélectronique selon la revendication 2,
**caractérisé en ce que**
la lentille (7) est une lentille de Fresnel.

4. Composant optoélectronique selon la revendication 2,
**caractérisé en ce que**
la lentille est une lentille asphérique ayant la forme d'un segment ellipsoïdal.

5. Composant optoélectronique selon la revendication 2,
**caractérisé en ce que**
la lentille présente un segment ellipsoïdal non symétrique en rotation.

6. Composant optoélectronique selon l'une des revendications 1 à 5,
**caractérisé en ce que**
des parois latérales (521) de l'évidement de substrat (52) comprennent un angle β d'environ 1° avec la normale d'une surface inférieure (522) de l'évidement de substrat (52).

7. Composant optoélectronique selon l'une des revendications précédentes,
**caractérisé en ce que**
la surface interne (53) de la région de réflecteur (51) présente une couche (54) qui augmente le pouvoir réfléchissant de la surface interne (53).

8. Composant optoélectronique selon la revendication 7,
**caractérisé en ce que**
la couche (54) comprend de l'argent.

9. Composant optoélectronique selon l'une des revendications précédentes,
**caractérisé en ce que**
la surface interne (53) de la région de réflecteur (51) est parabolique, tronconique ou sphérique.

10. Composant optoélectronique selon l'une des revendications précédentes,
**caractérisé en ce que**
il est utilisé dans une souris d'ordinateur, une barrière photoélectrique ou une imprimante.
